# EUROPÄISCHE PATENTSCHRIFT

(11) **EP 0 465 855 B1**
(45) Veröffentlichungstag und Bekanntmachung des Hinweises auf die Patenterteilung: **08.11.1995**
(21) Anmeldenummer: 91109552.9
(22) Anmeldetag: 11.06.1991
(51) Int. Cl.: H01L 21/306, H01L 21/312

(54) **Verfahren zur Herstellung lagerstabiler Oberflächen von polierten Siliciumscheiben**
Process for manufacturing polished silicon wafers having stabilized surfaces for storing
Procédé pour fabriquer des corps en silicium ayant des surfaces polies stabilisées pour le stockage

(30) Priorität: 13.06.1990 DE 4018984
(43) Veröffentlichungstag der Anmeldung: 15.01.1992
(73) Patentinhaber: Wacker-Siltronic Gesellschaft für Halbleitermaterialien mbH, D-84489 Burghausen (DE)
(72) Erfinder: Fabry, Laszlo, Dr., W-8261 Emmerting (DE); Grundner, Manfred, Dr., W-8263 Burghausen (DE); John, Peter, Dr., W-8263 Burghausen (DE); Feichtner, Wolfgang, A-5122 Ach (AT); Graef, Dieter, Dr., W-8263 Burghausen (DE); Winklharrer, Rosemarie, W-8261 Marktl (DE)
(74) Vertreter: Rimböck, Karl-Heinz, Dr.

(56) Entgegenhaltungen:
- EP-A- 0 222 400
- EP-A- 0 222 400
- EP-A- 0 222 400
- EP-A- 0 344 764
- EP-A- 0 353 518
- IBM TECHNICAL DISCLOSURE BULLETIN. Bd. 26, Nr. 12, Mai 1984, NEW YORK US Seiten6456 - 6457; V. CAZCARRA ET AL.: 'Improvements to surface characteristics ofsilicon wafers'

## Beschreibung

Die Erfindung betrifft ein Verfahren zur Herstellung lagerstabiler Oberflächen von polierten Siliciumscheiben durch oxidierende Behandlung und nachfolgende Einwirkung von siliciumorganischen Verbindungen.

Bedingt durch die räumliche und zeitliche Trennung zwischen der Herstellung von Halbleiterscheiben als Ausgangsmaterial und ihrer Weiterverarbeitung zu elektronischen Bauelementen als dem eigentlichen Endprodukt kommt es für die Scheiben oft zu unterschiedlich langen Transport- und Lagerzeiten. Von den Bauelementeherstellern wird dabei verlangt, daß die eingesetzten Halbleiterscheiben ungeachtet dieser Zeitdauer und der in deren Verlauf einwirkenden Einflüsse stets eine gleiche und reproduzierbare Oberflächenqualität aufweisen und dadurch ein reproduzierbares Verhalten bei den empfindlichen Herstellungsprozessen gewährleisten.

Andererseits ist bekannt, daß die beim Poliervorgang hergestellte einwandfreie Scheibenoberfläche bereits unmittelbar nach dessen Beendigung einer Fülle von Einwirkungen, z.B. durch Waschlösungen, Wasser und insbesondere die umgebende Atmosphäre ausgesetzt ist, die die Oberflächenqualität beeinflussen können. Dabei verdienen die atmosphärischen Einflüsse bei Transport und Lagerung, beispielsweise wegen der unterschiedlichen Zeitdauer und der oft großen klimatisch und/oder jahreszeitlich bedingten Unterschiede zwischen den verschiedenen Herstellerländern (Temperatur, Luftfeuchtigkeit und -kontamination z.B. mit Kohlenwasserstoffen) besondere Beachtung, da sie zu unterschiedlichem Verhalten der Scheiben bei den Eingangstests und/oder manchen Prozeßschritten bei der Bauelementeherstellung führen können.

Auch mit dem von W. Kern und D. Puotinen in RCA Review, June 1970, S.187-206 angegebenen Verfahren (sog. "RCA-Reinigung"), bei dem die polierte Scheibenoberfläche durch oxidative Behandlung, z.B. durch Eintauchen in eine Wasserstoffperoxid/Ammoniaklösung, mit einer dünnen Schicht aus teilweise hydratisiertem Siliciumdioxid überzogen wird, kann in der Regel die Kontamination der Oberfläche mit den nahezu allgegenwärtigen Kohlenwasserstoffen auf Dauer nicht verhindert werden. Zudem ändert sich, vor allem während längerer Lagerzeiten, aufgrund von Alterungseffekten auch die Struktur der Schutzschicht, was beispielsweise bei epitaktischen Prozessen oder thermischen Oxidationsschritten zu schleierartigen Eintrübungen ("haze") auf der polierten Oberfläche führen kann, die sich z.B. bei Überprüfung der Scheibenoberfläche im gebündelten Licht als diffuse Oberflächenreflexionen bemerkbar machen.

Dieser Effekt läßt sich gemäß der EP-A- 0 222 440 bzw. der entsprechenden US-PS 4,724,171 dadurch verhindern, daß die oxidierte Siliciumoberfläche mit Hexamethyldisilazan behandelt wird, wobei die Schutzwirkung damit erklärt wird, daß die OH-Gruppen der Scheibenoberfläche unter Trimethylsilylierung reagieren und dadurch dem vermutlich unter Wasserabspaltung zwischen verschiedenen OH-Gruppen ablaufenden Alterungsprozeß entzogen sind. Die solcherart behandelten Siliciumscheiben zeigen eine ausgezeichnete Lagerstabilität, besitzen aber eine von den Bauelementeherstellern wenig geschätzte hydrophobe Scheibenoberfläche, die überdies noch verhältnismäßig kohlenstoffreich ist (theoretisch drei Methylgruppen pro gebundenes Silicium). Ein auf eine solche hydrophobe Scheibenoberfläche aufgebrachter Wassertropfen zieht sich beispielsweise zusammen und nimmt manchmal sogar nahezu Kugelform an, während er auf einer hydrophilen Scheibenoberfläche sich ausbreitet und bisweilen sogar verläuft. Mit Hilfe des Benetzungswinkels zwischen der Scheiben- und der Tropfenoberfläche lassen sich die hydrophilen bzw. hydrophoben Oberflächeneigenschaften und ihre Veränderung bei der Lagerung testen und zumindest annähernd erfassen.

Die Aufgabe der Erfindung lag darin, ein weiteres Verfahren anzugeben, nach dem sich Siliciumoberflächen mit verbesserter Lagerstabilität erhalten lassen und welches insbesondere die kontrollierte Einstellung der Oberflächeneigenschaften zwischen mehr hydrophilem oder mehr hydrophobem Zustand sowie eine geringe Kohlenstoffbelegung der Scheibenoberfläche ermöglicht.

Gelöst wird die Aufgabe durch ein Verfahren der eingangs genannten Art, welches dadurch gekennzeichnet ist, daß als einwirkende siliciumorganische Verbindungen solche ausgewählt werden, die mindestens einen hydrolysierbar an Silicium gebunden und mindestens einen hydrophile Eigenschaften aufweisenden Rest im Molekül enthalten.

Die vorausgehende oxidierende Behandlung der Siliciumscheiben, durch welche ihre Oberfläche mit einer dünnen Oxidschicht überzogen wird, kann in der bekannten Weise z.B. in wäßriger alkalischer, insbesondere ammoniakalischer Wasserstoffperoxidlösung (beispielsweise analog dem Vorgehen bei der "RCA-Reinigung"), in wäßriger saurer, insbesondere salzsaurer Wasserstoffperoxidlösung oder in Ozon-haltiger wäßriger Lösung vorgenommen werden. Gleichfalls geeignet sind Lösungen, die beispielsweise Hypochlorite wie etwa Natriumhypochlorit als Oxidationsmittel enthalten. Ebenso können die Scheiben in alkalischer Lösung anodisch oxidiert werden. In den letztgenannten Fällen ist jedoch eine mögliche Kontamination der Scheibenoberfläche mit störenden Kationen zu beachten. Des weiteren besteht auch die Möglichkeit der Oxidation über die Gasphase, die z.B. durch Einwirkung von Ozon oder als sog. thermische Oxidation in trockenen oder feuchten Sauerstoff enthaltender Atmosphäre vorgenommen werden kann.

Im Anschluß an eine solche, ggf. auch aus einer Kombination mehrerer Schritte bestehende oxidierende Behandlung werden die Scheiben, die in der Regel in einseitig oder zweiseitig polierter Form vorliegen und somit mindestens eine polierte Scheibenoberfläche aufweisen, vorteilhaft noch gewaschen und getrocknet, um störende Nebenreaktionen mit den nachfolgend zur Einwirkung gebrachten siliciumorganischen Verbindungen zu verhindern. Zweckmäßig werden die Scheiben dieser Einwirkung möglichst unmittelbar im Anschluß an die oxidierende Behandlung unterworfen, obwohl sich erfahrungsgemäß Wartezeiten von bis zu etwa 12 Stunden als noch tolerierbar erwiesen haben.

Die vorgesehenen siliciumorganischen Verbindungen können als Einzelverbindungen oder als zwei- oder mehrkomponentige Gemische eingesetzt werden.

Grundsätzlich ist es möglich, die jeweils als Reagens ausgewählten siliciumorganischen Einzelverbindungen oder Gemische in flüssiger Form, vorteilhaft in einem Lösungsmittel wie etwa Trifluortrichlorethan gelöst, zur Einwirkung auf die Scheibenoberfläche zu bringen, beispielsweise durch Aufsprühen, Aufgießen, Aufschleudern oder Eintauchen. Günstiger und schon aus Reinheitsgründen bevorzugt ist jedoch die Einwirkung über die Gasphase, vorteilhaft über ein mit den vorgesehenen Verbindungen angereichertes Trägergas oder Trägergasgemisch wie Stickstoff, Argon, Wasserstoff, Kohlendioxid, Freone (wie etwa CF₂Cl₂) oder Luft, wobei ggf. die Oxidationsempfindlichkeit der Verbindungen zu berücksichtigen ist. Die Anreicherung kann dabei in der bekannten Weise z.B. über Dosiereinrichtungen wie temperaturkontrollierte Verdampfer ("bubbler") vorgenommen und gesteuert werden. Für die Begasung der Scheiben eignen sich die in der Halbleitertechnik für Gasbehandlungen üblichen Reaktionskammern oder Rezipienten. Eine besonders einfache Möglichkeit besteht darin, eine geringe Menge, d.h. in der Regel einen oder mehrere Tropfen, des Reagens in die vorgesehene Verpackung einzubringen und auf diese Weise eine zur Reaktion mit der Scheibenoberfläche geeignete Gasphase zu erzeugen.

Vorteilhaft werden, insbesondere im Hinblick auf die letztere Variante, solche siliciumorganische Verbindungen ausgewählt, deren Dampfdruck bei den üblichen klimatischen Bedingungen genügend hoch ist, um ohne zusätzliche Maßnahmen einen für die Wechselwirkung mit der Scheibenoberfläche ausreichend hohen Anteil in der Gasphase zu gewährleisten. Im allgemeinen wird diese Anforderung von solchen Verbindungen am besten erfüllt, deren Dampfdruck bei Normalbedingungen (25°C/1000 hPa) einem Wert von mindestens 0.5, bevorzugt 5 bis 500 hPa entspricht. Erfahrungsgemäß lassen sich jedoch sogar Verbindungen mit noch niedrigeren Dampfdrücken einsetzen, da die Scheibenoberfläche selbst mit geringen Anteilen derartiger siliciumorganischer Verbindungen in der umgebenden Atmosphäre zu reagieren vermag.

Als günstig hat sich der Einsatz von solchen siliciumorganischen Verbindungen erwiesen, bei denen der mindestens eine hydrolysierbar an Silicium gebundene Rest ein Fluor-, Chlor-, Brom-, Hydroxy- oder Alkoxy-, insbesondere Methoxy- oder Ethoxyrest ist. Auch siliciumorganische Verbindungen mit mehr als einem hydrolysierbar an Silicium gebundenen Rest im Molekül lassen sich einsetzen, wobei vorzugsweise Alkoxy-, insbesondere Ethoxy-, und bevorzugt Methoxyreste in Frage kommen. Beispiele für solche mehrere hydrolysierbar an Silicium gebundene Reste im Molekül enthaltende Verbindungen sind etwa Tetraethoxy- oder Tetramethoxysilan.

Grundsätzlich eignen sich die genannten Reste, insbesondere die Hydroxy- und Alkoxy-, vorzugsweise Methoxy- oder Ethoxyreste, auch als hydrophile Eigenschaften aufweisende Reste, sowie auch Alkylcarboxyreste da sich in Gegenwart von Wasser bzw. wässrigen sauren oder alkalischen Lösungen ihre Bindung zum Silicium der Scheibenoberfläche hydrolytisch spalten kann und dadurch letztlich wieder eine hydrophile Scheibenoberfläche gebildet wird. Gleichfalls geeignet sind Reste, die über ein Kohlenstoffatom an das Silicium gebunden sind und eine oder mehrere hydrophile Eigenschaften aufweisende funktionelle Gruppen tragen, wie etwa Hydroxymethyl- oder Hydroxyethylderivate, Glykolderivate oder Derivate von Carbonsäuren bzw. Carbonsäureanhydriden, wie etwa Acetyl- oder Acrylsäurereste oder Bernsteinsäureanhydridreste.

Durch die Anzahl der hydrophilen Reste und/oder die mehr oder weniger stark ausgeprägte Hydrophilie der im Molekül an Silicium gebundenen Reste bei den jeweils ausgewählten siliciumorganischen Verbindungen läßt sich somit der resultierende hydrophile Charakter der Scheibenoberfläche beeinflussen. Letztlich ermöglicht es das erfindungsgemäße Verfahren daher, je nach Bedarf die Scheibenoberflächen auf stark hydrophile, schwach hydrophile oder sogar annähernd hydrophobe Eigenschaften einzustellen. Beispielsweise lassen sich durch die Einwirkung von Tetramethoxysilan stärker hydrophile Scheibenoberflächen herstellen als durch die Einwirkung von Dimethoxydimethylsilan.

Bei Verbindungen analog der letztgenannten, die also nicht nur Substituenten enthalten, deren Bindung an das Silicium hydrolysierbar ist bzw. die hydrophile Eigenschaften aufweisen, haben sich als weitere Substituenten Alkylreste bewährt, wobei insbesondere solche in Frage kommen, die möglichst wenig Kohlenstoffatome enthalten. Bevorzugt werden daher Alkyl- oder Dialkylderivate eingesetzt, wobei insbesondere die Methyl- oder Dimethylverbindungen sowie die Ethyl- oder Diethylverbindungen sich als vorteilhaft erwiesen haben. Letztlich enthalten derartige, vor allem für die Bereitstellung weniger stark hydrophiler Scheibenoberflächen geeignete siliciumorganische Verbindungen also maximal zwei direkt an Silicium gebundene Kohlenstoffatome im Molekül.

Beispiele für erfahrungsgemäß besonders gut geeignete siliciumorganische Verbindungen mit mindestens einem hydrolysierbar an Silicium gebundenen und einem hydrophilen Rest, die gleichzeitig einen verhältnismäßig niedrigen Kohlenstoffanteil aufweisen, sind Tetramethoxysilan, Methoxychlordimethylsilan, Gemische dieser beiden Verbindungen, bevorzugt im Verhältnis von 1:3 bis 1:9, Gemische von Tetramethoxysilan und Dimethoxymethylchlorsilan, vorteilhaft im selben Mischungsbereich, sowie Di(2-chlorethoxy)dimethylsilan oder Dimethyldimethoxysilan .

Ein Vorteil des Verfahrens liegt darin, daß die eigentliche Einwirkung der Verbindungen auf die Scheibenoberfläche in den meisten Fällen bereits bei Raumtemperatur vorgenommen werden kann. Grundsätzlich ist es jedoch nicht ausgeschlossen, demgegenüber erhöhte Temperaturen anzuwenden, wobei sich Temperaturen bis 150°C, vorzugsweise 20 bis 60°C als gut geeignet erwiesen haben.

Die erforderlichen Einwirkungszeiten variieren im allgemeinen mit der Reaktivität der jeweils eingesetzten Verbindungen und werden zweckmäßig an Hand von Vorversuchen ermittelt. In der Regel sind jedoch Zeiträume von etwa 5 bis 200 Minuten für eine wirksame Behandlung der Scheibenoberfläche ausreichend, falls nicht ohnehin auf die Verfahrensvariante zurückgegriffen wird, daß die Scheiben in der Verpackung permanent einer mit den gewählten siliciumorganischen Verbindungen angereicherten Atmosphäre ausgesetzt werden.

Die Wirkung der jeweils ausgewählten siliciumorganischen Verbindungen beruht vermutlich darauf, daß der mindestens eine hydrolysierbar an Silicium gebundene Rest mit auf der oxidativ behandelten Scheibenoberfläche vorhandenen SiOH-Gruppen zu reagieren vermag, wobei unter Abspaltung der entsprechenden Wasserstoffverbindung des hydrolysierbaren Restes (z.B. Methanol, Ethanol, Wasser, Chlorwasserstoff u.s.w.) in einer Art Kondensationsreaktion der verbleibende Silylrest über eine Si-O-Si-Bindung an die Scheibenoberfläche gebunden wird. Ein besonderer Vorteil liegt dabei darin, daß die dabei freiwerdenden Reaktionsprodukte entweder keinen Einfluß auf die Siliciumoberfläche ausüben können (wie etwa Methanol) oder aber sogar zur Aktivierung hydrophiler Zentren dienen können (wie etwa Wasser, das z.B. Carbonsäureanhydride oder Methoxygruppen aktivieren kann).

Die solcherart behandelten Oberflächen von Siliciumscheiben zeigen auch bei äußerst widrigen Lagerbedingungen eine ausgezeichnete Lagerstabilität, wie etwa bei der als "Tropentest" bezeichneten mehrtägigen oder -wöchigen Lagerung bei 35°C in einer mit Wasserdampf gesättigten Atmosphäre. Dies gilt beispielsweise für die Resistenz gegenüber Änderungen der hydrophilen Eigenschaften der Scheibenoberfläche wie auch für die Zunahme der auf ihr festgestellten Anzahl von Partikeln, die ein wichtiges Annahme- oder Zurückweisungskriterium bei den Eingangstests der Bauelementehersteller darstellen. Wegen der geringeren Haftungskräfte an hydrophilen Oberflächen lassen sich die Partikel auch verglichen mit hydrophoben Scheiben leichter abreinigen. Weiterhin verringert der hydrophile und damit lipophobe Charakter der Scheibenoberfläche auch deutlich die Adsorption von Kohlenwasserstoffen und damit die unerwünschte SiC-Bildung bei nachgeschalteten Hochtemperaturschritten.

Des weiteren lassen sich die Siliciumscheiben auch nach langer Lagerung problemlos in die üblichen Prozesse zur Bauelementeherstellung einschleusen. Eine hydrophile Scheibenoberfläche bietet dabei den Vorteil, daß die in der Regel auf hydrophile Scheibenoberflächen abgestimmten Eingangsprozesse bei den Bauelementeherstellern keiner Umstellung bedürfen.

Überdies kann die bei dem erfindungsgemäßen Verfahren gebildete Oberflächenschicht leicht wieder dadurch entfernt und der ursprüngliche hydrophile Oberflächenzustand hergestellt werden, daß die Scheiben einer hydrolytischen Behandlung in alkalischer oder bevorzugt saurer wässriger Lösung unterzogen werden, durch welche die gebildeten Si-O-Si-Bindungen wieder aufgespalten werden. Der besondere Vorteil liegt dabei darin, daß diese Spaltung bereits unter milden Bedingungen abläuft und daher unter Einsatz von schwach alkalischen oder bevorzugt schwach sauren wässrigen Lösungen vorgenommen werden kann. An einen solchen Schritt kann dann die eigentliche Weiterverarbeitung angeschlossen werden.

Grundsätzlich kann jedoch eine solche einen geeigneten Eingangszustand der Scheibenoberfläche erzeugende Behandlung auch in der konventionellen Art und Weise erfolgen. Beispielsweise kann die Scheibenoberfläche vor dem eigentlichen ersten Prozeßschritt, in der Regel einer Oxidation in wässrigem Medium, einer thermischen Oxidation oder einer die siliciumorganische Schicht ablösenden Behandlung durch Flußsäure unterzogen werden und steht somit in dem für nachfolgende Prozeßschritte gewünschten kohlenstoffarmen Eingangszustand zur Verfügung.

Nachstehend wird die Erfindung an Hand von Ausführungsbeispielen näher erläutert:

### Beispiel 1:

Hundertfünfzig Siliciumscheiben (Durchmesser ca. 150 mm, (100)-Orientierung) wurden im Anschluß an eine in üblicher Weise durchgeführte Zweiseitenpolitur zunächst von den Polierrückständen befreit und anschließend einer aus zwei Teilschritten bestehenden oxidierenden Reinigung unterzogen, wobei auf eine 1-minütige Behandlung mit ca. 0.6 Gew.-%iger wässriger Flußsäure eine 10-minütige Behandlung in ammoniakalischer Wasserstoffperoxidlösung folgte. Diese beiden Teilschritte entsprachen damit im wesentlichen denen der sog. "RCA-Reinigung". Nach abschließendem Spülen und Trocknen lagen die Scheiben mit oxidierten polierten Oberflächen vor, die hydrophile Eigenschaften aufwiesen. Ein zum Test auf eine Scheibe im Zentrum aufgebrachter Wassertropfen (Tropfenvolumen ca. 10 µl) verlief vollständig und ließ damit starke Hydrophilie der Oberfläche erkennen.

Nun wurden Gruppen von jeweils 25 Scheiben in eine für die Lagerung und den Versand von Halbleiterscheiben übliche, aus Trägerelement sowie Boden- und Deckelteil bestehende Verpackungseinheit aus Polyethylen gegeben.

In den Verpackungseinheiten wurde nun auf verschiedene Weise jeweils eine Atmosphäre aufgebaut, die für das erfindungsgemäße Verfahren geeignete siliciumorganische Verbindungen enthielt. Daraufhin wurde die Verpackung gasdicht mit einer Polyethylenfolie umhüllt, und die in ihr befindlichen Scheiben wurden der eingestellten Atmosphäre für eine bestimmte Einwirkungsdauer bei Raumtemperatur ausgesetzt.

Danach wurden jeder Verpackung 5 Scheiben entnommen und mittels einer halbquantitativen Testmethode auf Hydrophilie bzw. Hydrophobie der Scheibenoberfläche untersucht. Zu diesem Zweck wurde auf die waagerecht ausgerichtete Scheibe im Zentrum mit Hilfe einer Tropfpipette ein Tropfen vollentsalzten Wassers von ca. 10 µl Volumen aufgebracht. Erfahrungsgemäß zieht sich bei zunehmend hydrophoben Oberflächeneigenschaften der Tropfen immer mehr zusammen und nimmt annähernd Kugelform an, während er mit zunehmender Hydrophilie der Scheibenoberfläche sich immer mehr ausbreitet und abflacht und schließlich verläuft. Eine annähernd quantitative Erfassung ist an Hand des Benetzungswinkels möglich, der sich zwischen Tropfen und Scheibenoberfläche ausbildet und beispielsweise besonders elegant mit Hilfe einer Videokamera gemessen werden kann, wenn diese so auf die Scheibe gerichtet ist, daß die Scheibenoberfläche als gerade Linie und der Tropfen als Projektion einer mehr oder weniger stark deformierten Kugel abgebildet wird. Als Benetzungswinkel wird dann der Winkel gemessen, den eine an die Flüssigkeitsoberfläche am Kontaktrand mit der Scheibenoberfläche gelegte Tangente mit der Scheibenebene einschließt. Dabei deuten Werte oberhalb 25° auf einen zunehmend hydrophoben, unterhalb dieses Wertes auf einen zunehmend hydrophilen Charakter der Scheibenoberfläche hin.

In die Verpackung A waren, nach der Beschickung mit Scheiben, vor dem Verschließen 55 µl Di(2-Chlorethoxy)dimethylsilan zugetropft worden. Nach einer zweistündigen Einwirkungszeit ergab bei den entnommenen Scheiben die Messung des Benetzungswinkels einen Wert von ca. 65°, was auf einen hydrophoben Charakter der Scheibenoberfläche schließen ließ.

Der Innenraum der Verpackung B wurde nach der Beschickung mit Scheiben mit einem Tetramethoxysilan/Stickstoffgemisch gespült, wobei der Silananteil im Trägergas mit Hilfe eines von diesem durchströmten, mit dem Silan gefüllten "Bubbler" eingestellt wurde. Danach wurde die Verpackung geschlossen, und für ca. 20 Minuten die Atmosphäre in Wechselwirkung mit den Scheibenoberflächen treten gelassen. Bei den danach entnommenen Scheiben ergab sich ein Benetzungswinkel von ca. 20°, entsprechend einem deutlich hydrophilen Charakter der Scheibenoberfläche.

In die Verpackung C wurde nach der Beschickung mit Scheiben ein Gemisch von Tetramethoxysilan und Chlormethoxydimethylsilan in einer Menge von 50 µl zugetropft; das Mischungsverhältnis (Volumenanteile) betrug 1:9. Nach zwanzigminütiger Einwirkungsdauer bei geschlossener Verpackung zeigten die entnommenen Scheiben einen Benetzungswinkel von ca. 60° und damit einen hydrophoben Charakter.

In die Verpackung D wurde nach der Beschickung mit Scheiben ein Gemisch von Tetramethoxysilan und Chlormethoxydimethylsilan in einer Menge von 50 µl zugetropft; das Mischungsverhältnis (Volumenanteile) betrug 1:4. Nach zwanzigminütiger Einwirkungsdauer bei geschlossener Verpackung zeigten die entnommenen Scheiben einen Benetzungswinkel von ca. 60° und damit einen hydrophoben Charakter.

### Beispiel 2:

Die in Beispiel 1 in den Verpackungen A bis D verbliebenen Scheiben (jeweils 20 Exemplare) wurden, nach raschem Verschließen der Verpackung, einem Test ihrer Lagerstabilität unterzogen. Dazu wurden die geschlossenen Verpackungen in einer Klimakammer für fünf Tage bei 35°C in mit Wasserdampf gesättigter Luft gehalten.

In einem Kontrollversuch wurden in einer Verpackung E zwanzig Scheiben der gleichen Behandlung unterzogen, die lediglich die in Beispiel 1 beschriebenen beiden Teilschritte der oxidierenden Reinigungsprozedur erfahren hatten und somit mit hydrophiler Oberfläche vorlagen.

In einem weiteren Kontrollversuch wurden in einer Verpackung F zwanzig Scheiben der gleichen Behandlung unterzogen, die im Anschluß an die oxidierende Behandlung in der bekannten Weise durch Einwirkung von Hexamethyldisilazan eine Trimethylsilylierung ihrer Oberfläche (gemäß der eingangs bereits erwähnten US-PS 4,724,171) erfahren hatten.

Im Anschluß an die bisweilen als "Tropentest" bezeichnete Behandlung in der Klimakammer wurden die Scheiben entnommen; aus jeder Gruppe wurde bei jeweils 5 Scheiben erneut der Benetzungswinkel vermessen, während die restlichen Scheiben daraufhin untersucht wurden, ob sich in der Klimakammer die meist als "haze" bezeichneten milchigen Eintrübungen auf der Scheibenoberfläche ausgebildet hatten. Diese Untersuchung wurde an Hand der Intensität des von der Scheibenoberfläche ausgehenden diffusen Streulichtes bei Einstrahlung von Laserlicht und Vergleich mit einer einwandfreien Referenzscheibe vorgenommen.

Bei den Scheiben aus der Verpackung A betrug der Benetzungswinkel unverändert 65°. Die Scheibenoberflächen waren vollständig "haze"-frei.

Bei den Scheiben aus der Verpackung B hatte der Benetzungswinkel den Wert von 20° beibehalten; die Scheibenoberflächen ließen keinerlei "haze" erkennen.

Bei den Scheiben aus der Verpackung C betrug der Benetzungswinkel unverändert 60°. Die Scheibenoberflächen waren vollständig "haze"-frei.

Bei den Scheiben aus der Verpackung D hatte sich der Benetzungswinkel von 60° auf 64° vergrößert; die Scheibenoberflächen ließen keinerlei "haze" erkennen.

Die Scheiben aus der Verpackung E waren nach wie vor so stark hydrophil, daß der aufgebrachte Wassertropfen verlief. Allerdings zeigten die Oberflächen aller Scheiben deutliche Spuren von "haze".

Die Scheiben aus der Verpackung F waren zu Anfang und Ende des "Tropentests" deutlich hydrophob und zeigten unverändert einen Benetzungswinkel von 45°. Die Scheibenoberflächen waren vollständig frei von "haze".

### Beispiel 3:

Nach Abschluß des "Tropentests" wurden die Scheiben aus den Verpackungen A bis D durch Eintauchen in wäßrige salzsaure Wasserstoffperoxidlösung (1 Teil Salzsäure/1 Teil Wasserstoffperoxid/6 Teile Wasser, Temperatur ca. 75°C, Zeitdauer ca. 10 min) einer Behandlung in wäßriger saurer oxidierender Lösung unterzogen, um die aufgetragene Silanschicht wieder zu hydrophilieren. Anschließend wurden die Scheiben gewaschen und getrocknet.

Der danach durchgeführte Wassertropfentest zeigte, daß alle auf die Scheibenoberfläche aufgebrachten Tropfen verliefen, was eine stark ausgeprägte Hydrophilie erkennen ließ. Somit waren durch die hydrolytische Behandlung die Scheiben wieder in einen ihrem bei der oxidierenden Behandlung vorliegenden hydrophilen Oberflächenzustand entsprechenden Zustand überführt worden.

## Patentansprüche

1. Verfahren zur Herstellung lagerstabiler Oberflächen von polierten Siliciumscheiben durch oxidierende Behandlung und nachfolgende Einwirkung von siliciumorganischen Verbindungen, dadurch gekennzeichnet, daß als einwirkende siliciumorganische Verbindungen solche ausgewählt werden, die mindestens einen hydrolysierbar an Silicium gebundenen und mindestens einen hydrophile Eigenschaften aufweisenden Rest im Molekül enthalten.

2. Verfahren nach Anspruch 1, dadurch gekennzeichnet, daß Siliciumscheiben mit zumindest einer polierten Scheibenoberfläche ausgewählt werden.

3. Verfahren nach den Ansprüchen 1 oder 2, dadurch gekennzeichnet, daß die Einwirkung der siliciumorganischen Verbindungen über die Gasphase erfolgt.

4. Verfahren nach einem oder mehreren der Ansprüche 1 bis 3, dadurch gekennzeichnet, daß als einwirkende siliciumorganische Verbindungen solche ausgewählt werden, deren Dampfdruck bei 25°C und 1000 hPa mindestens 0.5 hPa entspricht.

5. Verfahren nach einem oder mehreren der Ansprüche 1 bis 4, dadurch gekennzeichnet, daß als einwirkende siliciumorganische Verbindungen solche ausgewählt werden, deren hydrolysierbar an Silicium gebundene Reste Fluor-, Chlor-, Brom-, Hydroxy-, oder Alkoxyreste sind.

6. Verfahren nach einem oder mehreren der Ansprüche 1 bis 5, dadurch gekennzeichnet, daß als einwirkende siliciumorganische Verbindungen solche ausgewählt werden, deren hydrophile Eigenschaften aufweisende Reste Hydroxy-, Alkoxy- oder Alkylcarboxyreste sind.

7. Verfahren nach den Ansprüchen 5 oder 6, dadurch gekennzeichnet, daß die Alkoxyreste Methoxy- oder Ethoxyreste sind.

8. Verfahren nach einem oder mehreren der Ansprüche 1 bis 7, dadurch gekennzeichnet, daß als einwirkende siliciumorganische Verbindungen solche ausgewählt werden, die pro Siliciumatom maximal 2 direkt an Silicium gebundene Kohlenstoffatome im Molekül enthalten.

9. Verfahren nach einem oder mehreren der Ansprüche 1 bis 8, dadurch gekennzeichnet, daß die oxidierende Behandlung der Siliciumscheiben mit Hilfe von wäßrigen alkalischen oder sauren, Wasserstoffperoxid enthaltenden Lösungen vorgenommen wird.

10. Verfahren nach einem oder mehreren der Ansprüche 1 bis 9, dadurch gekennzeichnet, daß die lagerstabilen Oberflächen vor der Weiterverarbeitung mit alkalischen oder sauren wässrigen Lösungen behandelt werden.

## Claims

1. Process for producing storage-stable surfaces of polished silicon wafers by oxidative treatment and subsequent exposure to organosilicon compounds, characterized in that, as active organosilicon compounds, those are selected which contain at least one radical in the molecule which is hydrolysably bound to silicon and at least one radical in the molecule having hydrophilic properties.

2. Process according to Claim 1, characterized in that silicon wafers with at least one polished wafer surface are selected.

3. Process according to Claims [sic] 1 or 2, characterized in that the exposure to the organosilicon compounds is carried out via the gas phase.

4. Process according to one or more of Claims 1 to 3, characterized in that, as active organosilicon compounds, those are selected whose vapour pressure at 25°C and 1000 hPa corresponds at least to 0.5 hPa.

5. Process according to one or more of Claims 1 to 4, characterized in that, as active organosilicon compounds, those are selected whose radicals which are hydrolysably bound to silicon are fluoro, chloro, bromo, hydroxy, or alkoxy radicals.

6. Process according to one or more of Claims 1 to 5, characterized in that, as active organosilicon compounds, those are selected whose radicals having hydrophilic properties are hydroxy, alkoxy or alkylcarboxy radicals.

7. Process according to Claims [sic] 5 or 6, characterized in that the alkoxy radicals are methoxy or ethoxy radicals.

8. Process according to one or more of Claims 1 to 7, characterized in that, as active organosilicon compounds, those are selected which contain a maximum of 2 carbon atoms in the molecule directly bound to silicon per silicon atom.

9. Process according to one or more of Claims 1 to 8, characterized in that the oxidative treatment of the silicon wafers is carried out with the aid of aqueous alkaline or acidic solutions containing hydrogen peroxide.

10. Process according to one or more of Claims 1 to 9, characterized in that the storage-stable surfaces are treated with alkaline or acidic aqueous solutions before the further treatment.

## Revendications

1. Procédé pour fabriquer des pastilles en silicium ayant des surfaces polies stabilisées pour le stockage par un traitement oxydant et par l'action consécutive de composés organosiliciques, caractérisé en ce que l'on choisit en tant que composés organosiliciques agissants des composés qui contiennent dans la molécule au moins un résidu hydrolysable lié au silicium et au moins un résidu présentant des propriétés hydrophiles.

2. Procédé selon la revendication 1, caractérisé en ce que l'on choisit des pastilles en silicium ayant au moins une surface de disque polie.

3. Procédé selon les revendications 1 ou 2, caractérisé en ce que l'action des composés organosiliciques se produit par l'intermédiaire de la phase gazeuse.

4. Procédé selon une ou plusieurs des revendications 1 à 3, caractérisé en ce que l'on choisit en tant que composés organosiliciques agissants des composés dont la pression de vapeur à 25°C et à 1 000 hPa correspond à au moins 0,5 hPa.

5. Procédé selon une ou plusieurs des revendications 1 à 4, caractérisé en ce que l'on choisit en tant que composés organosiliciques agissants des composés, dont les résidus hydrolysables liés au silicium sont des résidus fluor, chlore, brome, hydroxy ou alkoxy.

6. Procédé selon une ou plusieurs des revendications 1 à 5, caractérisé en ce que l'on choisit en tant que composés organosiliciques agissants des composés, dont les résidus présentant des propriétés hydrophiles sont des résidus hydroxy, alkoxy ou alkylcarboxy.

7. Procédé selon les revendications 5 ou 6, caractérisé en ce que les résidus alkoxy sont des résidus méthoxy ou éthoxy.

8. Procédé selon une ou plusieurs des revendications 1 à 7, caractérisé en ce que l'on choisit en tant que composés organosiliciques agissants des composés, qui contiennent dans la molécule par atome de silicium au plus 2 atomes de carbone directement liés au silicium.

9. Procédé selon une ou plusieurs des revendications 1 à 8, caractérisé en ce que le traitement oxydant des pastilles en silicium est effectué à l'aide de solutions aqueuses alcalines ou acides contenant du peroxyde d'hydrogène.

10. Procédé selon une ou plusieurs des revendications 1 à 9, caractérisé en ce que les surfaces stabilisées pour le stockage sont traitées avant le traitement ultérieur à l'aide de solutions aqueuses alcalines ou acides.
